Europäisches Patentamt

European Patent Office

Office européen des brevets

(19)

(11) Veröffentlichungsnummer: **0 256 541**
**A2**

(12) # EUROPÄISCHE PATENTANMELDUNG

(21) Anmeldenummer: **87111841.0**

(22) Anmeldetag: **15.08.87**

(51) Int. Cl.4: **H01R 11/18 , G01R 1/067**

(30) Priorität: **19.08.86 DE 3628116**
**11.09.86 DE 3630888**
**14.02.87 DE 3704711**

(43) Veröffentlichungstag der Anmeldung:
**24.02.88 Patentblatt 88/08**

(84) Benannte Vertragsstaaten:
**CH DE FR IT LI NL**

(71) Anmelder: **Feinmetall Gesellschaft mit
beschränkter Haftung
Zeppelinstrasse 2
D-7033 Herrenberg(DE)**

(72) Erfinder: **Krüger, Gustav, Dr.
Danziger Strasse 1
D-7033 Herrenberg(DE)**
Erfinder: **Hinnerwisch, Sven, Dipl.-Phys.
Akazienweg 7
D-7031 Nufringen(DE)**

(74) Vertreter: **König, Oskar, Dr.-Ing. Dipl.-Phys.
Klüpfelstrasse 6 Postfach 51
D-7000 Stuttgart 1(DE)**

(54) **Kontaktiervorrichtung.**

(57) Kontaktiervorrichtung (13) für Prüfvorrichtungen zum Prüfen von elektrischen oder elektronischen Prüflingen. Sie weist mindestens einen Federkontaktstift (12) auf, der ein Kolbenglied (20) und eine Feder (19) aufweist. Zur konstengünstigen Herstellung sind das Kolbenglied und die Feder gemeinsam durch ein einziges, einstückiges Blechteil gebildet.

FIG.2A

EP 0 256 541 A2

## Kontaktiervorrichtung

Die Erfindung betrifft eine Kontaktiervorrichtung für Prüfvorrichtungen gemäß dem Oberbegriff des Anspruches 1.

Solche Prüfvorrichtungen dienen dem Prüfen von elektrischen oder elektronischen Prüflingen, wie Leiterplatten, integrierten Strom-und Schaltkreisen oder dgl. auf elektrische Fehlerfreiheit. Bekannte Federkontaktstifte dieser Art (bspw.KRÜGER, "Prüfmittel zur elektrischen Prüfung von Leiterplatten für Uhren", Jahrbuch der Deutschen Gesellschaft für Chronometrie, Band 30, 1979, S. 269-276; DE-OS 35 07 464) weisen einen Zylinder auf, in dem der runden Querschnitt aufweisende massive Kolben des Kolbengliedes axial gleitbar gelagert ist. Dieser Kolben ist durch eine gesonderte, vorgespannte Schraubendruckfeder belastet, gegen deren Kraft er beim Prüfen des Prüflings durch die Prüflinge verschoben wird. Die Feder muß hierbei trotz der Kleinheit solcher Federkontakstifte relativ große Kontaktkräfte ausüben können, meist etwa 50 - 300 cN. Die elektrischen Übergangswiderstände zwischen den Teilen dieser Federkontaktstifte erhöhen die elektrischen Durchgangswiderstände und diese nehmen im allgemeinen dabei auch mit der Zahl der Lastwechsel zu. Das Kolbenglied und der Zylinder der bekannten Federkontaktstifte werden spanabhebend hergestellt, bspw. auf Drehmaschinen und die Schraubenfeder auf Federwindeautomaten. Je nach dem speziellen Verwendungszweck werden die Teile dann galvanisiert und in handbedienten Vorrichtungen oder auf Automaten montiert. Selbst wenn die einzelnen Fertigungsstufen auf Automaten erfolgen, sind die Kosten zur Herstellung solcher qualitativ hochwertiger Federkontaktstifte relativ hoch.

Es ist deshalb eine Aufgabe der Erfindung, eine Kontaktiervorrichtung der eingangs gennanten Art zu schaffen, welche sehr kostengünstig herzustellen und einfach zu montieren ist und in dem dem Normalfall entsprechenden Falle mehrerer oder vieler Federkontaktstifte auch besonders geringe Mittenabstände zwischen benachbarten, durch derartige Federkontaktstifte gleichzeitig zu kontaktierenden Stellen von Prüflingen zulassen kann.

Zur Lösung dieser Aufgabe ist erfindungsgemäß eine Kontaktiervorrichtung gemäß Anspruch 1 vorgesehen.

Indem die Feder zusammen mit dem Kolbenglied gemeinsam durch ein einziges einstückiges Blechteil gebildet ist, ist der Stab äußerst kostengünstig aus einem Blech herstellbar, bspw. zweckmäßig durch Herstellung seines Blechzuschnittes durch Stanzen, Ätzen oder dergl. und ggf.

noch spanlosem Verformen, wie Biegen, Prägen oder dergleichen. Nach seinem Stanzen, Ätzen oder dgl. und ggf. spanlosem Verformen braucht der Stab erforderlichenfalls nur noch entgratet und ggf. mit mindestens einer chemisch oder galvanisch aufgebrachten Beschichtung versehen zu werden, bspw. vernickelt, vergoldet oder dgl. zu werden. Eine oder mehrere solcher Beschichtungen können auch schon auf dem Blech vorgesehen sein, bevor der Zuschnitt für den betreffenden Stab von ihm durch Stanzen, Ätzen oder dgl. abgetrennt wird. Auch mehrschichtige Überzüge oder Beschichtungen sind in bei Federkontaktstiften an sich bekannter Weise selbstverständlich möglich. Die Dicke des Bleches, aus welchem der vorzugsweise flache Stab herzustellen ist, kann sehr gering sein, bspw. oft zweckmäßig mindestens 0,05 mm, insbesondere 0,1 bis 1 mm, vorzugsweise 0,2 bis 0,4 mm betragen, oft zweckmäßig ungefähr 0,25 bis 0,35 mm. Auch andere Blechdicken kommen je nach Ausführungsform in Frage. So können bei Stäben, die aus der Ebene des ursprünglichen Blechzuschnittes heraus verformt sind, besonders geringe Blechdicken vorgesehen sein, bspw. zweckmäßig ca. 0,09 bis 0,25 mm. Die maximale Breite des Stabes kann zweckmäßig gröber, vorzugsweise mehrfach gröber sein als die Dicke des ihn bildenden Bleches. Diese maximale Breite kann bspw. zweckmäßig mindestens 2-fach, vorzugsweise mindestens 3-fach größer als die Dicke des Bleches sein, vorzugsweise ungefähr 4-bis 20-fach, besonders zweckmäßig oft ca. 4-bis 10-fach.

Die Längsrichtung des Stabes kann einschließlich der seiner Feder vorzugsweise gerade sein.

Es ist zwar eine Kontaktiervorrichtung zum gleichzeitigen Abtasten einer Vielzahl von Kontaktstellen mittels rasteratig in einem Trägerblock eingesetzter federnder Tastelemente für Fernmeldeanlagen, insbesondere zum Abtasten der Kontaktstellen von gedruckten Leiterplatten, bekannt (DE-PS 1 790 052), bei der die Tastelemente als in einer Ebene mäanderförmig gebogene flache Federn ausgebildet sind, die in Bohrungen des Lagerkörpers und in Öffnungen der Abdeckplatten jeweils paarweise mit ihren flachen Seiten aneinanderliegend geführt sind und beidseitig des Trägerblockes mit ihren geradlinig auslaufenden Federenden zur Bildung von Tastspitzen einerseits und von Anschlußfahnen andererseits über den Trägerblock hinausragen. Diese Kontaktiervorrichtung ist jedoch baulich verhältnismäßig aufwendig, schon weil in jeder Bohrung des Lagerkörpers nebeneinander zwei Federn angeordnet sind und je zwei Tastelemente aus jeder Öffnung der dem Prüfling benachbarten Abdeckplatte herausragen. Die mit ihren flachen Seiten aneinander anliegenden Federn können sich hierbei gegenseitig stören und die Größe der sich bei der Prüfung von Prüflingen einstellenden Kontaktkräfte, die die beiden Tastspitzen jeweils auf dieselbe Kontakstelle eines Prüflings ausüben, unkontrolliert schwanken und entsprechend auch der von Ihnen gemeinsam geleitete Prüfstrom. Auch ist keine genaue Führung der Tastspitzen gewährleistet, weil die Tastelemente keine geradegeführten Kolben haben. Die Mittenabstände benachbarter, zu kontaktierender Stellen jedes Prüflings müssen in verhältnismäßig große Rastermaße aufweisendem Raster angeordnet sein, weil die paarweise Anordnung der als Federn ausgebildeten Tastelemente keine sehr kleinen Rastermaße zuläßt. Zwar ist es bei dieser Kontaktiervorrichtung auch möglich, die beiden Federn eines Federpaares durch die beiden Schenkel eines U-förmigen Biegeteiles zu bilden, deren freien Schenkelenden die Tastspitzen bilden, doch bildet ein solches Biegeteil keinen Stab, sondern ist ähnlich wie eine Haarnadel ausgebildet und an den erwähnten Nachteilen ändert sich hierdurch nichts.

Erfindungsgemäße Federkontaktstifte haben demgegenüber einfachere, kostengünstigere Bauart, genaue Führung der Kolbenglieder, lassen extrem geringe Mittenabstände benachbarter Federkontaktstifte in der Kontaktiervorrichtung zu, lassen gewünschte Kontaktkräfte recht genau erreichen und lassen vielfälige Ausbildung der Stäbe zur Anpassung an unterschiedliche Anforderungen zu.

Da ein Abschnitt des Stabes eine Feder bildet, muß zumindest dieser federnde Abschnitt des Stabes federelastische Eigenschaften haben. Zu diesem Zweck kann bspw. das Blech des Stabes aus Stahl, Kupfer-Beryllium, Nickel-Beryllium, Bronze, metallischen Verbundwerkstoffen oder sonstigen geeigneten Metallen oder Metallegierungen bestehen und ggf. auch noch durchgehend oder bereichsweise mit einer ein-oder mehrschichtigen metallischen Beschichtung bzw. Beschichtungen versehen sein, vorzugsweise aus Metallen oder Metallegierungen.

Es ist auch möglich, daß das den Stab bildende Blech noch in nicht federelastischem Zustand gestanzt oder dgl. und ggf. verformt, wie gebogen und/oder geprägt oder dgl. wird und erst dann zum Erhalt federelastischer Eigenschaften vergütet, gehärtet oder sonstwie behandelt wird. Zum Beispiel kann das Blech zunächst weiches Kupfer-Beryllium sein, und der aus ihm hergestellte Stab wird dann zur Vergütung bspw. 1 h bei ca. 300°C wärmebehandelt. Oder es werden nur dem die Feder bildenden Abschnitt des Stabes durch Vergütung, Härtung oder dgl. die für die Feder notwendigen federelastischen Eigenschaften gegeben und der oder die restlichen Bereiche des Stabes weisen ganz oder weitgehend andere Eigenschaften durch entsprechende Behandlung oder Nichtbehandlung auf. Bspw. kann bei Herstellung des Stabes aus Stahlblech das Kolbenglied so behandelt sein, daß es ein möglichst starre Eigenschaften aufweisendes Gefüge hat, bspw. durch Härten ohne anschließendes Vergüten, wogegen der die Feder bildende Abschnitt nach dem Härten noch zur Erzielung möglichst guter elastischer Federeigenschaften vergütet wird, bspw. einer geeigneten Temperaturbehandlung unterzogen wird.

Die Feder kann vorzugsweise eine flache Feder oder Flachfeder bilden. Die Feder kann besonders zweckmäßig schlangenförmigen Verlauf und/oder mindestens eine Durchbrechung aufweisen. Doch kommen auch andere Gestaltungen in Frage.

Wie erwähnt, können die Stäbe noch mit chemischen oder galvanischen oder auf sonstige Weise aufgebrachten Beschichtungen oder Überzügen versehen sein, die ihre gewünschten Eigenschaften noch verbessern, bspw. möglichst hohe Verschleißfestigkeit der Kolben der Kolbenglieder ergeben, usw.. Hierzu ist bspw. eine Hartvernicklung günstig und ggf. auch Überzüge oder Beschichtungen aus Edelmetallen oder Edelmetallegierungen, oder es können bereichsweise auch elektrisch isolierende Beschichtungen vorgesehen sein, usw.

Für die auszuübende Funktion muß der metallische Stab gut elektrisch leitend sein. Hier ist es von Vorteil, daß die Feder zusammen mit dem Kolbenglied ein einstückiges Bauteil bildet, so daß kein elektrischer Übergangswiderstand zwischen der Feder und dem Kolbenglied mehr besteht. Es kann dann der den Federkontakstift an die Prüfvorrichtung anschließende weiterführende elektrische Leiter zweckmäßig direkt an das rückwärtige Ende des Stabes angeschlossen sein. Bspw. kann hier ein elektrischer Leitungsdraht angelötet oder angeschweißt sein, oder das rückwärtige Ende des Stabes kann an einen Anschlußkontakt elastisch angedrückt sein, oder ein Anschlußkontakt kann an es angeklemmt sein, usw.. Hierdurch erhöht sich auch der elektrische Durchgangswiderstand dieses Federkontaktstiftes dan nicht mehr mit der Zahl der Lastwechsel.

Im einfachsten Fall kann der Federkontaktstift nur aus dem einstückigen Stab oder dem Stab und einem an ihm angesetzten gesonderten Kontaktkopf bestehen. Dies ermöglicht est auch, besonders geringe Mitten-und Seitenabstände zwischen benachbarten Federkontaktstiften zu erreichen, was das Kontaktieren entsprechend eng benachbarter Prüfpunkte von zu prüfenden Prüflingen ermöglicht. Die Gleitgeradführung für den Kolben des Kolbengliedes kann dann durch einen einen Kanal bildenden Schlitz einer Plattenanordnung, einer Platte oder eines sonstigen Gegenstandes gebildet sein, in den dieser Federkontaktstift eingesetzt ist. Diese Plattenanordnung oder dgl. kann dann mehrere oder sehr viele solcher Schlitze aufweisen, in die solche Federkontaktstifte eingesetzt sind oder eingesetzt werden können, und in denen vorzugsweise auch die Federn der Stäbe angeordnet sein können, so daß die Federn hierdurch auf einfache Weise gegen seitliches Ausknicken gesichert und auch geführt sind. Dabei können diese Federn in den Schlitzen vollständig angeordnet sein oder ggf. auch über sie etwas überstehen. Die Platte, Platten oder dgl. können dabei zweckmäßig aus elektrisch isolierendem Material, vorzugsweise aus Kunststoff, bestehen, so daß die Federkontaktstifte selbst keine elektrisch isolierenden Beschichtungen benötigen oder die Schlitze mit isolierenden Beschichtungen versehen werden müssen.

Da die Federkontaktstifte in der Kontaktiervorrichtung einzeln in getrennten Kanälen oder dgl. angeordnet und gegeneinander elektrisch isoliert sind und jeweils nur aus einem Stab bestehen oder nur einen Stab aufweisen, ergeben sie auch gleichmäßigeren Kontakt mit den Prüflingen und gleichmäßigere Durchgangswiderstände, als die paarweise aneinander anliegenden Tastelemente nach der DE-PS 17 90 052.

Der einzelne erfindungsgemäße Federkontaktstift dient beim Prüfen von Prüflingen dem Leiten eines Prüfstromes, der unabhängig von den von den anderen Federkontaktstiften der betreffenden Kontaktiervorrichtung einzeln geleiteten Prüfströme ist bzw. sein kann.

Dem erfindungsgemäßen Federkontaktstift können sich deshalb wegen der möglichen extrem geringen Mitten-und Seitenabstände zwischen benachbarten Federkontaktstiften auch Anwendungsgebiete erschließen, wo die herkömmlichen Federkontaktstifte nicht eingesetzt werden konnten. Sie können extrem kleine Rastermaße für die zu kontaktierenden Stellen von Prüflingen zulassen, insbesondere auch im Falle von nur in einzelnen Reihen angeordneten, zu kontaktierenden Stellen von Prüflingen, bspw. der Pads von Chips.

Die Montage dieser erfindungsgemäßen Federkontaktstifte ist äußerst einfach, da keine gesonderte Montage der Feder erfolgen muß, sondern nur der Stab in die betreffende, vorzugsweise flache Gleitgeradführung oder dgl. eingesetzt werden muß

In vielen Fällen kann zweckmäßig der Federkontaktstift eine nur ihm zugeordnete, gesonderte Gleitgeradführung aufweisen, die vorzugsweise ebenfalls aus Blech durch Stanzen, Ätzen oder dgl. und Biegen oder dgl. hergestellt sein kann, ggf.

jedoch auch aus anderen Materialien, wie Kunststoff, Keramik oder dgl. hergestellt sein kann. Diese Gleitgeradführung des Federkontaktstiftes kann dann in eine Kontaktiervorrichtung, bspw. in einen Prüfadapter oder dergl. einer Prüfvorrichtung, bspw. in eine Frontplatte eines Prüfadapters normalerweise zusammen mit mehreren oder vielen solcher Federkontaktstifte eingesetzt werden.

Auch ist es besonders günstig, wenn die beiden Längsendbereiche des Stabes durch die beiden Längsendbereiche des Blechzuschnittes, aus dem der Stab gebildet ist, gebildet sind.

Es seien folgende Definitionen gebracht:

Die Breite b des Stabes wird parallel zur geometrischen Breit-Längsmittelebene seines Kolbengliedes und senkrecht zu dessen Bewegungsrichtung und damit senkrecht zu dessen Längsrichtung gemessen.

Die Höhe h des Stabes wird einschließlich der Höhe seiner Feder senkrecht zur geometrischen Breit-Längsmittelebene des Kolbengliedes und senkrecht zu dessen Bewegungsrichtung und damit senkrecht zu dessen Längsrichtung gemessen.

Die geometrische Breit-Längsmittelebene des Kolbengliedes ist parallel zu dessen Breitenerstreckung und verläuft in halber maximaler Höhe des Kolbengliedes.

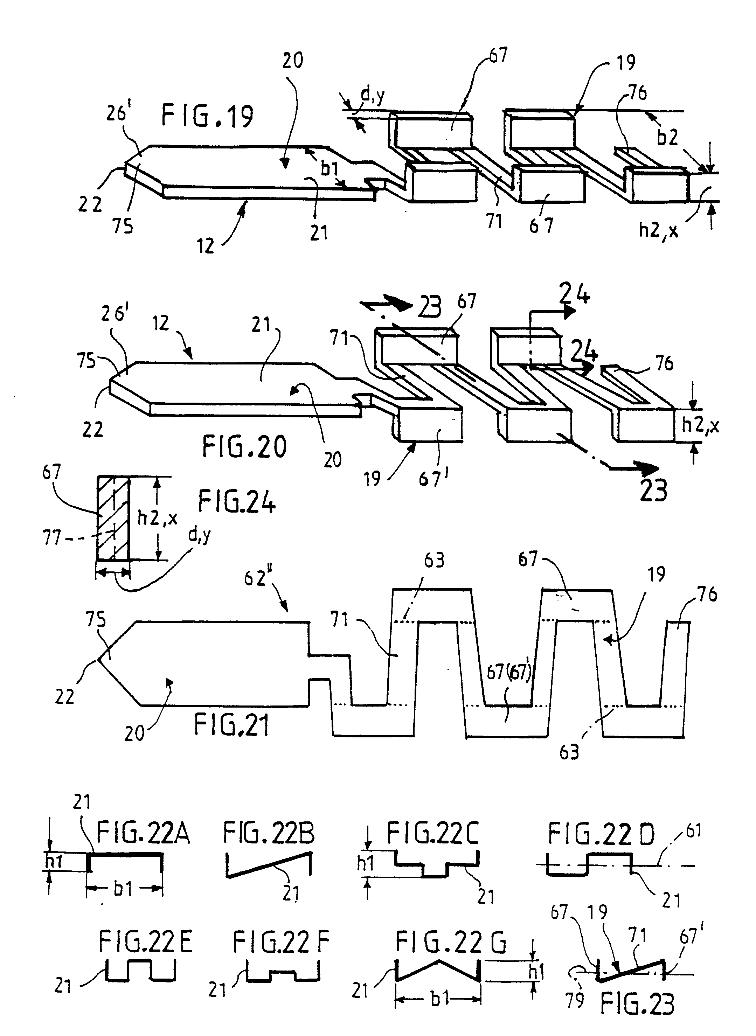

Die Querschnittsbreite (x) jedes Querschnittes des die Feder bildenden Bleches ist die parallel zur beim betriebsmäßigen Biegen vorliegenden neutralen Faser ( = Spannungsnullinie) (77) gemessene Querschnittsabmessung und die Querschnittshöhe (y) des betreffenden Querschnittes ist die hierzu senkrecht gemessene Querschnittsabmessung (y), wie es die Figuren 2C und 24 an Beispielen zeigen. Diese Querschnittsbreite und -höhe brauchen nicht mit der Breite und Höhe der Feder übereinzustimmen.

Bevorzugt kann vorgesehen sein, daß die maximale Breite des Kolbengliedes größer, vorzugsweise mindestens 2-fach größer als seine maximale Höhe ist und/oder daß die maximale Breite der Feder größer, vorzugsweise mindestens 2-fach größer als ihre maximale Höhe ist. Besonders zweckmäßig kann vorgesehen sein, daß die maximale Breite des Stabes größer, vorzugsweise mindestens 2-fach größer als seine maximale Höhe ist.

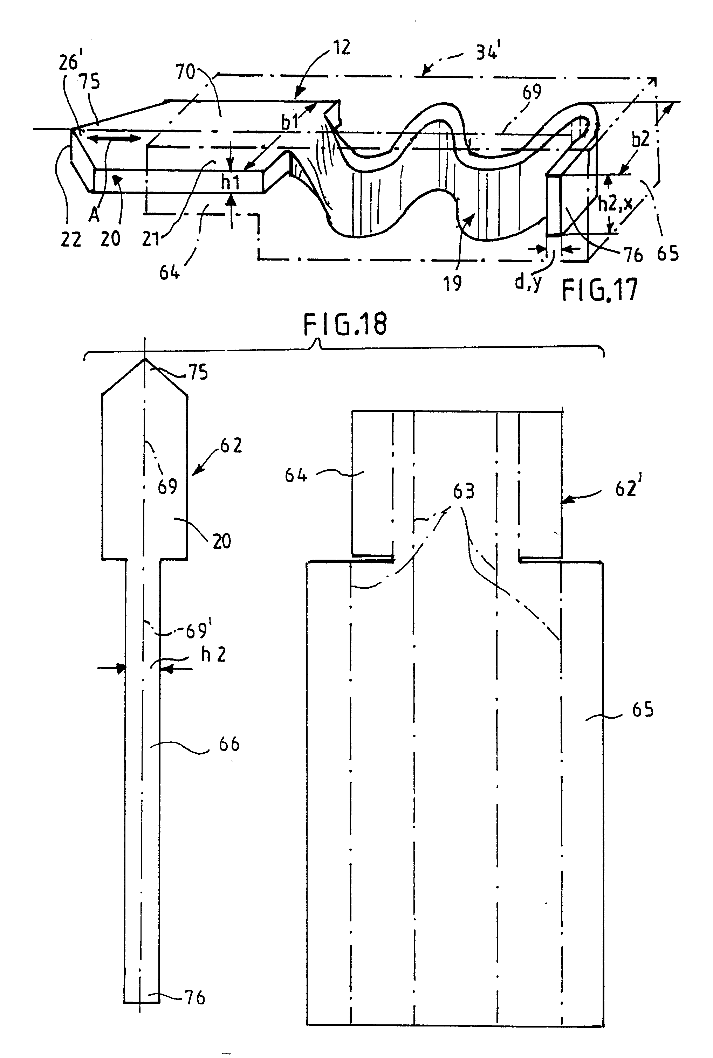

Bei einer bevorzugten, besonders hohe Bruchsicherheit der Feder ergebenden Ausführungsform ist vorgesehen, daß der die Feder bildende Blechbereich des Blechteiles des Stabes zumindest teilweise zur geometrischen Breit-Längsmittelebene des Kolbengliedes nicht parallel verläuft, vorzugsweise zu ihr geneigt und/oder ungefähr senkrecht gerichtet ist (Fig. 17,19,20), wobei der nicht paralleler Bereich oder mindestens ein nicht paralleler Bereich gewölbt und/oder eben oder sonstwie aus der Ebene des ursprünglich ebenen Blechzuschnittes herausgebogen sein kann.

In der Zeichnung sind Ausführungsbeispiele der Erfindung dargestellt. Es zeigen:

Fig. 1 eine ausschnittsweise Draufsicht auf eine Plattenanordnung einer nicht in weiteren Einzelheiten dargestellten Kontaktiervorrichtung eines Prüfadapters einer Prüfvorrichtung zum Prüfen von elektrischen oder elektronischen Prüflingen, wie Leiterplatten oder dgl.,

Fig. 2A einen Schnitt durch die Plattenanordnung nach Fig. 1 gesehen entlang der Schnittlinie 2-2,

Fig. 2B eine Seitenansicht auf die schmale Seite des flachen Stabes nach Fig. 2A,

Fig. 2C einen Schnitt durch die Feder des Stabes nach Fig. 2B, gesehen entlang der Schnittlinie 2C-2C,

Fig. 3 eine Variante der Fig. 2A,

Fig. 4 eine Variante der Fig. 2A in ausschnittsweiser Darstellung,

Fig. 5 eine stirnseitige Ansicht auf den einen flachen Stab bildenden Federkontaktstift der Fig. 4,

Fig. 6A und 6B Varianten des flachen Stabes nach Fig. 5, gesehen ebenfalls in stirnseitiger Ansicht,

Fig. 7 eine Seitenansicht eines Federkontaktstiftes gemäß einem weiteren Ausführungsbeispiel der Erfindung,

Fig. 8 einen Schnitt durch Fig. 7 gesehen entlang der Schnittlinie 8-8,

Fig. 9 eine Untenansicht des Federkontaktstiftes nach Fig. 7,

Fig. 10 einen Schnitt durch den Federkontaktstift nach Fig. 7, gesehen entlang der Schnittlinie 10-10,

Fig. 11 eine Seitenansicht eines Federkontaktstiftes gemäß einem weiteren Ausführungsbeispiel der Erfindung,

Fig. 12 13 und 14 Schnitte durch den Federkontaktstift nach Fig. 11, gesehen entlang den Schnittlinien 12-12, 13-13 bzw. 14-14,

Fig. 15 eine Variante der Fig. 2A.

Fig. 16 eine Ansicht eines flachen Stabes mit einer aus einer Ringreihe bestehenden Flachfeder gemäß einem weiteren Ausführungsbeispiel der Erfindung,

Fig. 17 eine schaubildliche Ansicht eines flachen Stabes eines Federkontaktstiftes, dessen Gleitgeradführung strichpunktiert angedeutet ist,

Fig. 18 die ebenen Blechzuschnitte, aus denen der Stab und die eine Hülse bildende Gleitgeradführung nach Fig. 17 durch Biegen hergestellt sind,

Fig. 19 und 20 je eine Variante des in Fig. 17 dargestellten Stabes ebenfalls in schaubildlicher Ansicht,

Fig. 21 den ebenen Blechzuschnitt, aus dem sowohl der Stab nach Fig. 19 als auch der nach Fig. 20 durch Biegen hergestellt sein kann,

Fig. 22A bis 22G Varianten von Profilen der Kolben der Stäbe nach den Fig. 17, 19 und 20, um die Höhe der Kolben denen der Federn ungefähr anzugleichen,

Fig. 23 einen Schnitt durch die Feder nach Fig. 20, gesehen entlang der Schnittlinie 23-23,

Fig. 24 einen Querschnitt durch das Blech der Feder nach Fig. 20, gesehen entlang der Schnittlinie 24-24.

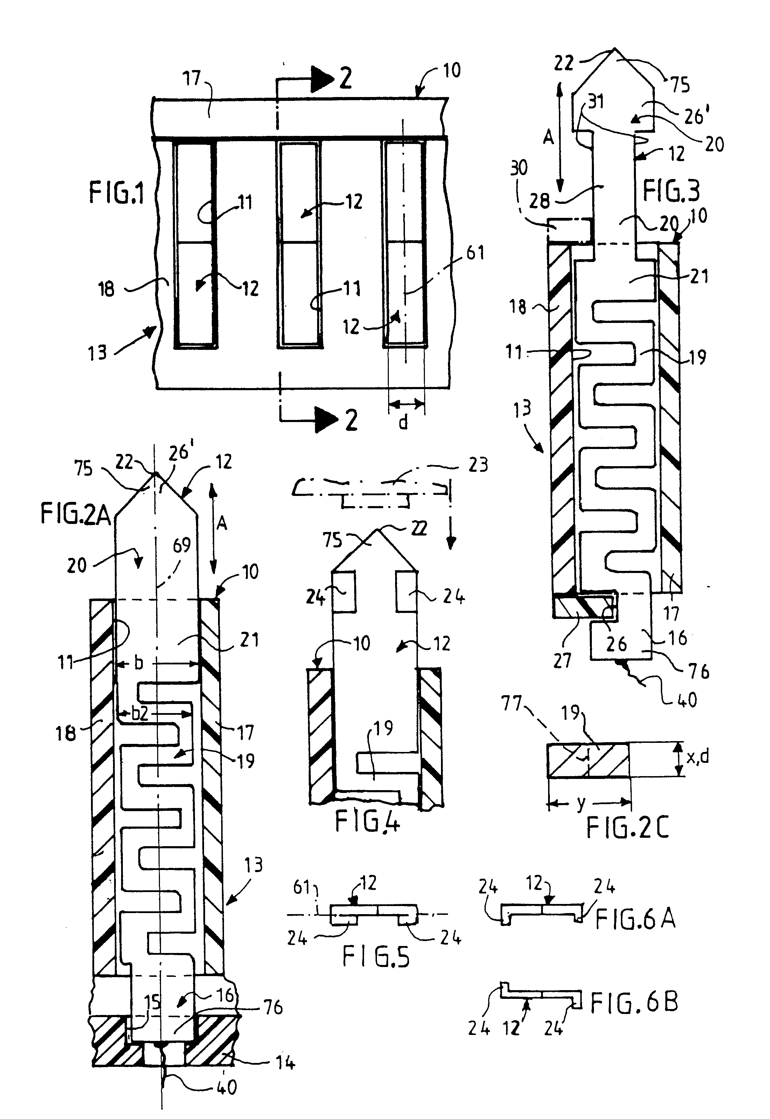

In Fig. 1 ist eine ausschnittsweise Draufsicht auf eine Kontaktiervorrichtung 13 dargestellt, die eine einen Block bildende Plattenanordnung 10 aufweist, die eine Vielzahl von im Querschnitt rechteckförmigen Kanälen oder Schlitzen 11 aufweist, wobei in jeden solchen Schlitz ein einziger, als flacher Stab ausgebildeter Federkontaktstift in der aus Fig. 2A ersichtlichen Weise eingesetzt ist. Dieser ein einstückiges einlagiges Blechteil bildende Flachstab 12 hat konstante Dicke und ist eben und seine Längsachse ist gerade. Anstelle der Plattenanordnung 10 kann ggf. auch eine einteilige Platte oder ein sonstiger Gegenstand, der der Führung der flachen, geraden Stäbe 12 dienende Schlitze 11 aufweist, vorgesehen sein. Die flachen Stäbe 12 sind mit ihren unteren Füßen 16 rechteckförmigen Querschnitts in eine im Abstand unterhalb der Plattenanordnung 10 angeordnete und mit ihr fest verbundene Stützplatte 14 aus Kunststoff eingesetzt, die abgestufte Durchgangsöffnungen 15 aufweist, auf deren jeweiliger Abstufung die rückwärtigen Enden der flachen Stäbe 12 aufsitzen, wodurch die axiale Stellung dieser rückwärtigen Enden der aufrechtstehenden flachen Stäbe 12 gesichert ist. Diese schlitzförmigen Öffnungen 15 der Stützplatte 14 können so schmal sein, daß diese rückwärtigen Enden 16 der Flachstäbe 12 in ihnen reibungsschlüssig gehalten sind. Der Kunststoff der Stützplatte 14 ist ebenso wie der der beiden Platten 17 und 18 der Plattenanordnung 10 elektrisch isolierend.

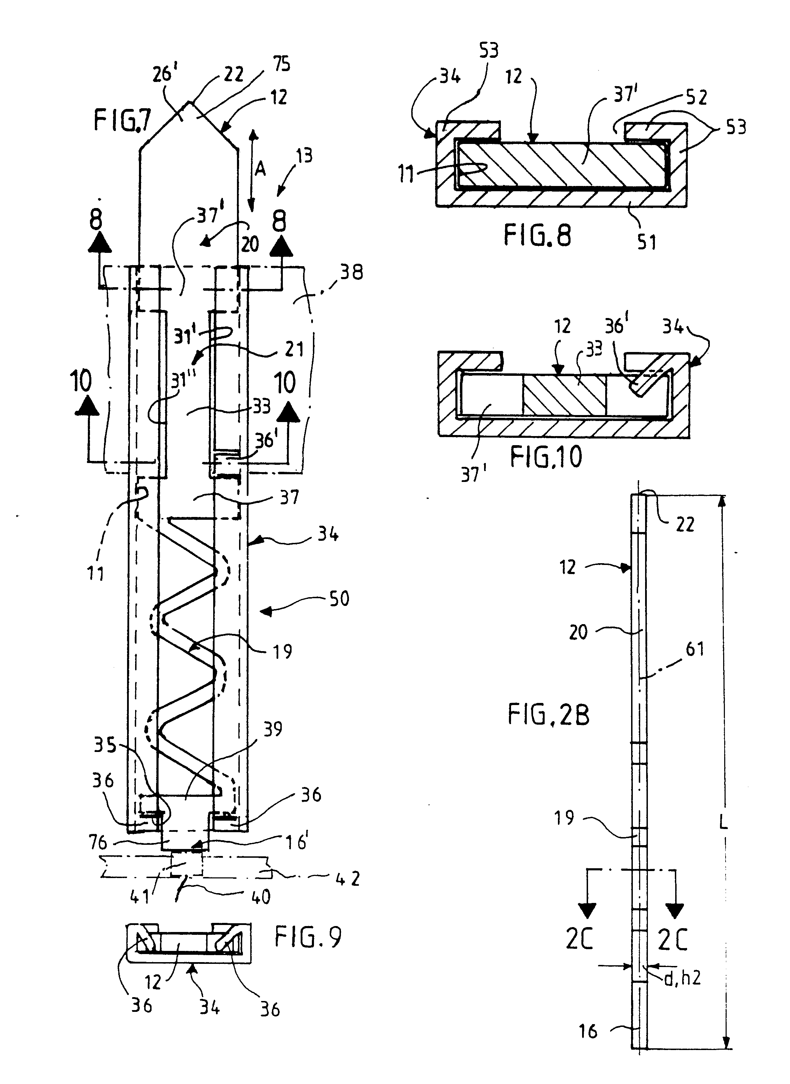

Die Platte 18 der Plattenanordnung 10 weist an ihrer einen Seite die zueinander parallel eingearbeiteten rechteckförmigen Schlitze 11 auf, die an dieser Seite durch eine an sie fest angesetzte ebene Platte 17 abgeschlossen sind, so daß die rechteckförmigen Durchgangsschlitze 11 hierdurch auf in der Herstellung einfache Weise gebildet sind. Eine solche Plattenanordnung 10 mit eingesetzten Federkontaktstiften 12 und Stützplatte 14 bildet eine Kontaktiervorrichtung 13, die einen Prüfadapter oder einen Modul eines Prüfadapters bilden kann oder es können an einem Prüfadapter ein solcher Modul oder eine Vielzahl oder eine Mehrzahl solcher Module angeordnet sein. Auch kann ein solcher Modul bei gleicher Herstellungsweise zwei Reihen solcher Schlitze ohne weiteres aufweisen. Dieser Modul oder diese Plattenanordnung 10 ist an einem Träger oder Gestell des Prüfadapters zusammen mit der Stützplatte 14 fest angeordnet. Der Prüfadapter kann in bekannter Weise an ein Testgerät der Prüfvorrichtung elektrisch angeschlossen sein, s. KRÜGER, wie oben, und seine Federkontaktstifte 12 können dem gleichzeitigen Kontaktieren von Stellen des jeweiligen Prüflings dienen. Der längliche metallische flache Stab 12 ist aus einem ebenen Blech vorzugsweise durch Stanzen hergestellt, dessen Dicke vorzugsweise 0,2 bis 0,4 mm, oft besonders zweckmäßig 0,25 bis 0,35 mm betragen kann. Solche Blechdicken kommen auch für andere Stäbe oft vorteilhaft in Frage. Er ist durchgehend eben und hat konstante Dicke d, siehe Fig. 2B, so daß die geometrische Breit-Längsmittelebene 61 seines Kolbengliedes 20, die in Fig. 1 und 2 B jeweils senkrecht zur Bildebene verläuft, eine Symmetrieebene des Stabes 12 ist, in die auch dessen Längsmittelachse 69 (Fig. 2A) fällt. Seine Länge L ist viel größer als seine maximale Breite b (Fig. 2A), vorzugsweise mindestens 10-fach größer, besonders zweckmäßig mindestens 25-fach größer. Diese maximale Breite b ist ihrerseits wesentlich größer als seine Dicke d. Er ist mit Gleitlagerspiel in dem betreffenden Schlitz 11 gelagert und durch seine Gestalt in ihm auch gegen Drehen gesichert. Er weist die aus den Fig. 1 bis 2B ersichtliche Gestalt auf. Und zwar weist er wie dargestellt eine in der Ebene des flachen Stabes 12 wellen-oder -schlangenförmig verlaufende Flachfeder 19 auf, die in Bezug auf die Längsachse 69 in der Ebene dieses Flachstabes 12 transversal verlaufend gewellt ist und die wie ersichtlich eine gekrümmte Biegefeder mit schlangenförmigen Windungen bildet. An diese Feder 19 schließt nach unten das kurze gerade Fußteil 16 und nach oben das flache Kolbenglied 20 jeweils einstückig an. Dieses flache Kolbenglied 20 bildet sowohl den in den Schlitz 11 mit Gleitlagerspiel axial gleitbar gelagerten, rechteckförmigen Querschnitt konstanter Breite aufweisenden geraden Kolben 21, den man auch als Flachkolben bezeichnen kann, als auch in diesem Ausführungsbeispiel die dem Inkontaktkommen mit Prüflingen, wie Leiterplatten oder dgl., von denen in Fig. 4 eine bei 23 ausschnittsweise strichpunktiert dargestellt ist, dienende Kontaktspitze 22. Der Kolben 21 ist also hier der konstante Breite aufweisende Bereich des Kolbengliedes 20, der in dem betreffenden Schlitz 11 durch ihn gleitgeführt werden kann. An das rechteckförmigen Querschnitt aufweisende Fußteil 16 ist ein weiterführender elektrischer Leitungsdraht 40 angelötet. Jeder Stab 12 bildet einen elektrischen Leiter, und diese Stäbe 12 sind einzeln gegeneinander elektrisch isoliert.

Die schlangenförmige Flachfeder 19 hat eine gerade Längsachse, die mit der Längsachse des Stabes 12 zusammen fällt, so daß Stab 12 ein Stab mit gerader Längsachse 69 ist. Die Feder 19 ist in diesem Ausführungsbeispiel nicht vorgespannt und so dimensioniert, daß sie bei den beim Prüfen von Prüflingen in Richtung des Doppelpfeiles A stattfindenden Hubbewegungen des Kolbengliedes 20 nicht in dem Schlitz 11 klemmen kann. Hierzu kann ihre Breite b2 (Fig. 2A) gleich groß oder, falls erforderlich, etwas kleiner als die des Kolbens 21 sein. Ihre Dicke entspricht der des Kolbengliedes 20 und ist also wesentlich kleiner als ihre Breite. Die Flachfeder 19 ist also ebenfalls in dem einen geraden Kanal bildenden Schlitz 11 konstanten lichten Querschnittes geführt und kann nicht quer zu seiner Längsrichtung ausknicken, sondern nur axial federn.

Bei der Prüfung von Prüflingen wird der Prüfling gleichzeitig an die Kontaktspitzen 22 der dreieckförmigen, flachen Kontaktköpfe 26' der flachen Stäbe 12 der Kontaktiervorrichtung oder -vorrichtung angedrückt und drückt diese nach unten gegen die Federkräfte der Federn 19. Nach Beendigung der Prüfung wird der Prüfling weggeführt und die Kolbenglieder 20 kehren dadurch in ihre Ausgangsstellungen zurück.

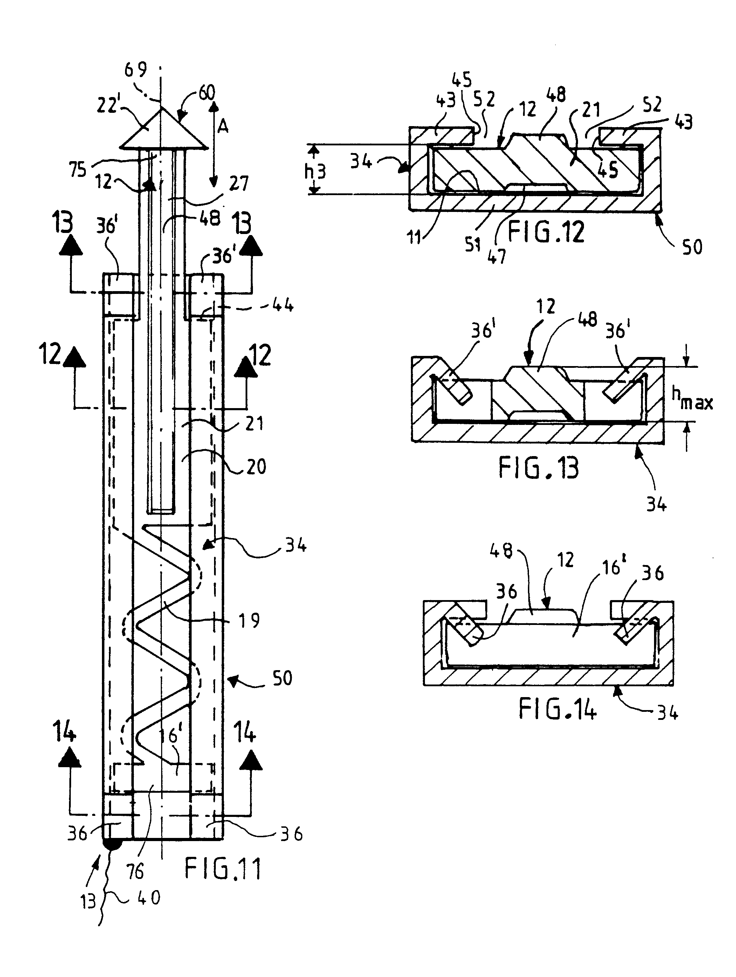

Wenn es erwünscht ist, den über den Schlitz 11 nach oben überstehenden oberen Endbereich des flachen Stabes 12 zu verstärken, kann dies auf einfache Weise dadurch bewirkt werden, indem an das diesen flachen Stab bildende Blechteil seitlich zwei Lappen 24 mit ausgestanzt werden, die dann, wie in Fig. 4 und 5 dargestellt, um 180° umgebogen werden. Es kann auch ihre Umbiegung um weniger als 180°, bspw. um jeweils 90° nach derselben Seite (Fig. 6A) oder nach entgegengesetzten Seiten (Fig. 6B) vorgesehen sein. Auch andere Versteifungen des flachen Stabes 12 sind möglich. Bspw. können hierzu zweckmäßig auch eine odere mehrere Einprägungen vorgesehen sein, die sich ggf. auch in die Geradführung mit hineinerstrecken können, wie es die Figuren 11 bis 14 an einem Ausführungsbeispiel zeigen.

Wie erwähnt, kann der flache Stab 12 noch mit mindestens einer chemischen oder galvanischen oder auf sonstige Weise aufgebrachten Beschichtung oder einem Überzug versehen sein, die seine gewünschten Eigenschaften noch verbessern, bspw. möglichst geringe elektrische Übergangswiderstände oder hohe Verschleißfestigkeit des Kolbens des Kolbengliedes ergeben, usw.

Bei dieser Feder 19 des Stabes 12 entspricht die parallel zur beim axialen Zusammendrücken der Feder vorliegenden neutralen Faser , wie 77, gemessene Querschnittsbreite x jedes ihrer Blechquerschnitte (Fig. 2C) der Dicke d des sie bildenden Bleches. Die hierzu senkrecht gemessene Querschnittshöhe y jedes solchen Querschnittes ist bei dieser Flachfeder 19 im Ausführungsbeispiel größer als d. Die Dicke d entspricht hier der Höhe der Feder und die Querschnittshöhe y verläuft also zu dieser Dicke d hier senkrecht. Die maximale Breite b2 dieser Feder 19 verläuft hier parallel zur Querschnittshöhe y.

Die Feder 19 bildet einen transversalen, "stehenden" Wellenzug, dessen "Schwingungsebene" als "Wellenenbene" bezeichnet sei, um deutlich zu machen, daß dieser Wellenzug nicht transversal schwingt. Die Wellenebene sei dabei diejenige "Schwingungsebene", die in halber Höhe der transversal gewellten Feder 19 verläuft. In diesem Ausführungsbeispiel nach den Figuren 1 bis 2C entspricht diese Wellenebene der geometrischen Breit-Längsmittelebene 61.

Die Kontaktiervorrichtung 13 nach Fig. 3 unterscheidet sich von der nach Fig. 2A im wesentlichen dadurch, daß der Fuß 16 des den Federkontaktstift bildenden flachen Stabes 12, den man ebenfalls als Flachstab mit gerader Längsachse bezeichnen kann, eine Ausnehmung 26 aufweist, in die eine Platte 27 zur Sicherung der axialen Stellung dieses Fußes 16 formschlüssig eingreift. Dieses Platte 27 ist an der die Schlitze 11 aufweisenden Platte 18 befestigt. Diese Platte 18 wie auch die Platte 17, können den Platten 17 und 18 nach Fig. 1 und 2 entsprechen, doch wird hier keine Stützplatte 14 benötigt, so daß die Kontaktiervorrichtung baulich ganz besonders einfach und kostengünstig ist. Sie weist normalerweise mehrere oder viele solcher Federkontaktstifte bildenden Stäbe 12 auf, die jeweils dem gleichzeitigen Kontaktieren von getrennten Prüf-oder Kontaktstellen des jeweiligen Prüflings für Prüfzwecke dienen und zum getrennten Leiten von beim Prüfen von Prüflingen auftretenden Prüfströmen gegeneinander elektrisch isoliert sind.

Wenn es erwünscht ist, den Hub des hier einen in der Breite verjüngten längeren Bereich 28 aufweisenden Kolbengliedes 20 des flachen Stabes 12 zu begrenzen, kann zu diesem Zweck eine strichpunktiert dargestellte Platte 30 auf der Oberseite der Plattenanordnung 10 befestigt sein, die in eine der beiden, den verjüngten Bereich 28 bildenden Einbuchtungen 31 eingreift. Dieser verjüngte gerade Bereich 28 bildet einen flachen Schaft des Kolbengliedes 20, der dessen flachen Kolben 21 mit dessen verbreitertem, ebenfalls flachen Kontaktkopf 26′ einstückig verbindet. Bei Vorhandensein einer solchen Platte 30, die sich über die Länge der betreffenden Platte 18 allen Schlitzen 11 dieser Platte gleichzeitig zugeordnet erstrecken kann (was auch für die Platte 27 entsprechend gilt), kann auch vorgesehen sein, daß die - schlangenförmig transversal gewellte Feder 19, deren Wellenebene der geometrischen Breit-Längsmittelebene des Kolbengliedes 20 entspricht, ständig vorgespannt ist, indem sie so lang ausgebildet ist, daß sie den Kolben 21 unter Vorspannung an die Platte 30 andrückt. Man muß also dann diese ebenfalls eine gekrümmte, eine gerade Längsachse aufweisende Biegefeder bildende Feder 19 entsprechend lang ausbilden. Es kann dann auch das Fußteil 16 wegfallen und die - schlangenförmige Flachfeder 19 allein an der Platte 27 anliegen.

Bei dem Ausführungsbeispiel nach den Figuren 7 bis 10 besteht der Federkontaktstift 50 aus einem ebenen flachen Stab 12 mit gerader Längsachse und einer als gesondertes Teil ausgebildeten und nur ihm zugeordneten metallischen, geraden Gleitgeradführung 34. Diese Gleitgeradführung 34 kann zusammen mit den Gleitgeradführungen 34 einer Vielzahl solcher Federkontaktstifte 50 in eine strichpunktiert angedeutete Frontplatte 38 eines eine Kontaktiervorrichtung bildenden Prüfadapters eingesetzt sein, in der sie gegen axiales Verschieben nach unten gesichert oder auf sonstige Weise in einer vorbestimmten Stellung gehalten ist. Diese Frontplatte 38 kann für jeden in sie eingesetzten Federkontaktstift einen eigenen Schlitz aufweisen, in welchen die betreffende Gleitgeradführung 34 formschlüssig eingesetzt und unbeweglich gehalten ist. Oder eine solche Kontaktiervorrichtung bildet einen Modul eines Prüfadapters oder dergl.. Diese eine gerade Stange bildende Gleitgeradführung 34, die in wesentlichen einen Profilstab C-förmigen Querschnittes bildet, ist aus einem einstückigen Blech rechteckförmigen Zuschnittes gebildet, indem dieses Blech in die aus Fig. 8 ersichtliche C-förmige Gestalt gebogen ist und so einen einen geraden Kanal bildenden Geradführungsschlitz 11 zur Geradführung des Kolbens 21 des geraden Kolbengliedes 20 bildet, welcher Schlitz 11 durch die ebene Breitseite 51 und die beiden einen Zwischenraum 52 zwischen sich lassenden umgebogenen L-förmigen Schenkel 53 der Geradführung 34 begrenzt ist. Auch der Stab 12 besteht aus Blech des seiner Gestalt ensprechenden Zuschnittes.

An dieses Kolbenglied 20 schließt nach unten einstückig die zick-zack-förmig gestaltete, ebene Flachfeder 19 an, die, wie dargestellt, in derselben Ebene wie das Kolbenglied 20 und der Fuß 16′ transversal verläuft und deren Wellenebene der geometrischen Breit-Längsebene des Kolbengliedes 20 entspricht. Die wellen-oder - schlangenförmige, ebenfalls eine gekrümmte Biegefeder mit gerader Längsachse bildende Flachfeder 19 kann hier vorteilhaft eben sein und also in derselben Ebene wie das zugeordnete Kolbenglied 20 und der Fuß 16' verlaufen . Diese Ebene verläuft in Längsrichtung des flachen Stabes 12 parallel zu seiner Breitseite. Auch der gesamte flache Stab 12 ist in diesem Ausführungsbeispiel eben und weist konstante Dick auf, so daß er ein Stanzteil sein kann. Der an die Feder 19 nach unten einstückig anschließende Fuß 16' sitzt mit einer Schulter 35 auf zwei in der Untenansicht der Figur 9 zu sehenden, schräg nach innen abgewinkelten Lappen 36 der Geradführung 34 auf, die also am unteren Endbereich der Geradführung 34 aus den umgebogenen Bereichen des diese Geradführung bildenden Bleches durch entsprechendes stärkeres Umbiegen gebildet sind. Dieser Fuß 16' bildet in diesem Ausführungsbeispiel zweckmäßig ebenfalls einen Kolben, indem sein innerhalb der Gleitgeradführung 34 befindlicher, oberhalb der Lappen 36 befindlicher Bereich konstanten, rechteckförmigen Querschnittes einen mit Gleitlagerspiel in der Gleitgeradführung 34 axial beweglich gelagerten Kolben 39 bildet und so der untere, schmalere Endbereich 16' des flachen Stabes 12 ebenfalls geradegeführt ist, was die Gesamtführung des flachen Stabes 12 verbessert.

Auch aus einem anderen, weiter oben befindlichen, entsprechend stark umgebogenen, kurzen Abschnitt des einen der umgebogenen Bereiche der Geradführung 34 ist ebenfalls ein schräg nach innen führender, schmaler Lappen 36' gebildet, der in eine Einbuchtung 31' des Kolbens 21 des oberen Kolbengliedes 20 hineinragt und einen Anschlag für die höchste Stellung des unteren mit Gleitlagerspiel geführten Bereiches 37 des Kolbens 32 bildet, an den dieser Bereich 37 durch die hierbei vorgespannte Feder 19 angedrückt wird, solange das Kolbenglied 20 des flachen Stabes 12 gegen die Wirkung der Feder 19 nicht nach unten gedrückt ist. Diese Feder 19 ist in dem einen Kanal bildenden geraden Schlitz 11 gegen seitliches Ausknicken geführt.

Der Kolbenbereich 37 bewirkt zusammen mit dem im Abstand oberhalb von ihm befindlichen weiteren Kolbenbereich 37' die axiale Führung des massiven Kolbengliedes 20 in der C-förmigen Querschnitt aufweisenden Gleitgeradführung 34. Der flache einlagige Stab 12 ist einschließlich seines dreieckförmigen flachen Kontaktkopfes 26' des flachen Stabes 12 einstückig. Der Kolben 21 weist hier somit die geradegeführten Bereiche 37, 37' und den sie verbindenden schmaleren, durch Einbuchtungen 31', 31'' gebildeten streifenförmigen Mittelbereich 33 auf. Der Kolben 21 ist hier also der Bereich des Kolbengliedes 20, der sich in Geradführung 34 bei maximaler Eintauchtiefe befinden kann.

In diesem Ausführungsbeispiel steht der Fuß 16' des flachen Stabes 12 über die Gleitgeradführung 34 nach unten über und kann bspw. durch die Feder 19 elastisch an einen in einer strichpunktiert angedeuteten Anschlußplatte 42 angeordneten Anschlußkontakt 41 zum elektrischen Anschluß dieses flachen Stabes 12 an einen weiterführenden Leiter 40 ständig angedrückt sein. Diese Andrückkraft kann durch die Feder 19 aufgebracht sein, indem die Anschlußplatte 42 an der Kontaktiervorrichtung 13, die einem Prüfadapter oder einem Teil eines Prüfadapters bilden kann, so hoch angeordnet wird, daß sie die Schulter 35 von den Lappen 36 abhebt.

Bei dem Ausführungsbeispiel nach den Figuren 11 bis 14 ist an den flachen, einstückigen, eine gerade Längsachse 69 aufweisenden Stab 12 an seinem oberen Ende ein gesonderter, dreieckförmiger Kontaktkopf 22' konstanter Dicke angeschweißt, der bspw. aus einem härteren und/oder verschließfesteren Material als das Blech des flachen Stabes 12 besteht, so daß der aus den Teilen 12 und 22' bestehende Gesamtstab 60 zweiteilig ist.

Dieser gerade Federkontaktstift 50 weist wiederum eine stangenförmige, im Querschnitt C-förmige, gesonderte, vorzugsweise aus Blech durch Stanzen und Biegen hergestellte flache, gerade Gleitgeradführung 34 auf, in dessen geradem Kanal 11 der Kolben 21 des geraden Kolbengliedes 20 dieses flachen Stabes 12 axial gleitbar formschlüssig geradegeführt ist. An den flachen Kolben 21 des flachen Kolbengliedes 20 schließt nach oben einstückig ein Schaft 27 verringerter Breite an, der den Kontaktkopf 22' trägt, so daß hier, wie dargestellt, der Kolben 21 sich ständig vollständig innerhalb der Gleitgeradführung 34 befindet. An den Kolben 21 schließt nach unten die ebene Flachfeder 19 an, die in einem ebenen Fußteil 16' endet, das ebenfalls einen in der Gleitgeradführung 34 geführten zusätzlichen Kolben bilden kann und gemäß Figur 14 auf zwei nach schräg innen gebogenen Lappen 36 des Bleches der Gleitgeradführung 34 aufsitzt. Die Feder 19, deren Wellenebene parallel zur geometrischen Breit-/Längsmittelebene des Kolbengliedes 20 verläuft, kann vorgespannt sein, da sie die am oberen Ende des Kolbens 21 vorhandene Schulter 44 des flachen Stabes 12 an zwei gemäß Figur 13 ebenfalls Schräg nach innen gebogene, aus dem Blech der Gleitgeradführung 34 gebildete Lappen 36' andrücken kann. Diese Lappen 36' sind erst nach Einsetzen des Kolbens 21 in die Gleitgeradführung 34 nach innen umgebogen und halten so den flachen Stab 12 zusammen mit den Lappen 36 in der Gleitgeradführung 34. Beim Prüfen von Prüflingen kontaktieren diese die Spitze des Kontaktkopfes 22' und drücken das Kolbenglied 20 gegen die Kraft der Feder 19 nach unten. Diese Feder 19 drückt bei Abnahme des jeweiligen Prüflinges dann wieder das Kolbenglied 20 bis zum Anliegen ihrer Schulter 44 an die Lappen 36' nach oben. Den Stab 12 - wie auch den Gesamtstab 60 kann man wegen seiner flachen Bauart ebenfalls als Flachstab 12 bzw. Gesamtflachstab 60 bezeichnen.

Die formschlüssige Führung des Kolbens 21 ist aus Fig. 12 ersichtlich.

Und zwar weist in diesem Ausführungsbeispiel das im wesentlichen rechteckförmigen Querschnitt aufweisende Kolbenglied 20 des Stabes 12 eine an dem Kontaktkopf 22' beginnende und bis kurz vor das untere Ende des Kolbens 21 reichende gerade Prägung auf, die auf der der ebenen Breitseite 51 der Gleitgeradführung 34 zugewendeten Seite des Kolbengliedes 20 eine flache Rinne 47 und auf der anderen Flachseite des Kolbengliedes eine entsprechende flache Auswölbung 48 bildet, die die maximale Dicke des Federkontaktstiftes 50 jedoch nicht verbreitert, da die Erhöhung 48 im Bereich der Gleitgeradführung 34 in den Spalt 52 zwischen den Längskanten 45 der Schenkel 43 hineinragt. Diese Prägung kann sich falls erwünscht auch über die ganze Länge des flachen Stabes 12 erstrecken oder sonstwie länger oder kürzer als dargestellt sein. Die Breite des Schlitzes 11 dieser Gleitgeradführung 34 ist, wie aus den Figuren 12 bis 14 ersichtlich, so groß, daß der Kolben 21 mit nur geringem Gleitlagerseitenspiel in diesem Schlitz 11 geradegeführt gelagert ist. Durch diese die Rinne 47 und die Auswölbung 48 bildende Prägung des Kolbengliedes 20 wird praktisch ohne Mehraufwand dessen Steifigkeit unter Erhöhung seiner maximalen Höhe $h_{max}$ (Fig. 13) erhöht, wobie jedoch die Vergrößerung der Höhe sich nicht in einer Vergrößerung der lichten Höhe h3 der Geradführung 34 und der maximalen Höhe dieses Federkontaktstiftes auswirkt.

In diesem Ausführungsbeispiel ist zum elektrischen Anschluß dieses Federkontaktstiftes 50 an die Prüfvorrichtung an deren metallische Gleitgeradführung 34 ein weiterführender Leiter 40 angeschlossen. An sich ist es günstiger, einen solchen weiterführenden Leiter direkt an den Flachstab anzuschließen, wie es in den anderen Ausführungsbeispielen dargestellt ist, da dann der elektrische Übergangswiderstand zwischen dem Flachstab 12 und der Gleitgeradführung 34 keine Rolle spielt. Dieser elektrische Übergangswiderstand ist bei diesem Ausführungsbeispiel jedoch durch die dargestellte Konstruktion gering.

Anstatt der dargestellten Gleitgeradführung 34 mit C-förmigem Querschnitt kann sie auch als flache Hülse ausgebildet werden, indem man die beiden umgebogenen Schenkel 53 bzw. 43 des betreffenden Bleches so breit macht, daß sie sich berühren und so diese Hülse einen umfangsseitig geschlossenen Kanal vorzugsweise ungefähr rechteckförmigen Querschnittes für die Führung des Kolbens und die Feder bildet. Die Schenkel einer solchen Hülse kann man dann zur Versteifung von ihr, falls erwünscht, auch an mindestens einer Stelle miteinander durch Punktschweißen fest verbinden.

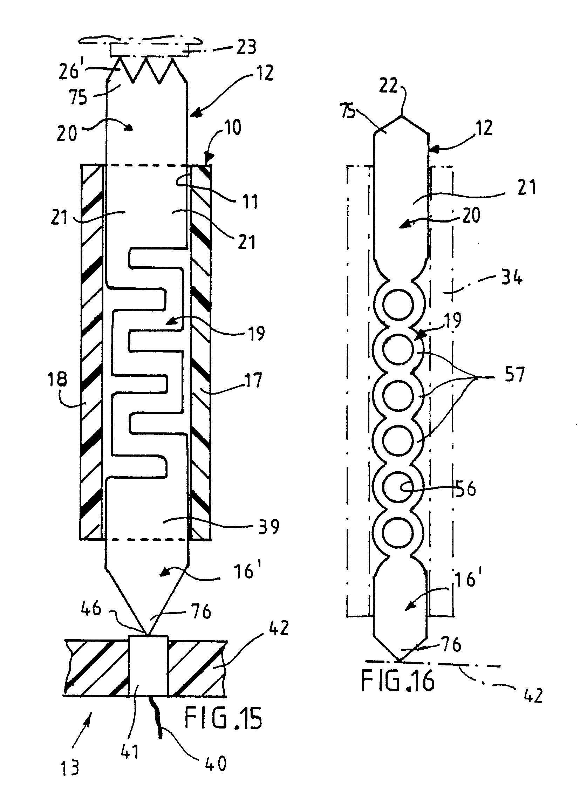

Anstatt die Flachfeder 19 wellen- oder -schlangenförmig auszubilden, kann sie auch andere Ausbildungen haben, bspw. als Ring oder eine gerade Reihe von einstückig aneinander anschließenden Ringen 57, wie es bei dem Stab 12 nach Fig. 16 dargestellt ist, welche Ringe 57 hier rund sind und so runde Durchbrüche 56 aufweisen. Auch die Feder 19 in Fig. 16 ist im Betrieb auf Biegung in Längsrichtung beansprucht, indem ihre Ringe mehr oder weniger zusammengedrückt werden. Der Stab 12 nach Fig. 16 kann bspw. eben sein und konstante Dicke aufweisen und sein Kolben 21 und der sich bei 42 abstützende Fuß 16' können in einer Geradführung formschlüssig geradegeführt sein.

In Fig. 15 ist eine Variante eines einstückigen ebenen flachen Stabes 12 nach Fig. 2A dargestellt. Und zwar bildet in Fig. 15 der an die Flachfeder 19 einstückig anschließende Fuß 16' des flachen Stabes 12 einen zusatzlichen zu dem Kolben 21 vorhandenen zweiten flachen Kolben 39, der in dem Schlitz 11 der Plattenanordnung 10 ebenfalls mit Gleitlagerspiel axial gleitbar geradegeführt ist. Damit ist auch der untere Endbereich 16' des eine gerade Längsachse aufweisenen flachen Stabes 12 geradegeführt und die Gesamtführung des flachen Stabes 12 besonders gut. Dieser den zweiten Kolben 39 aufweisende Fuß 16' ist am unteren Ende spitz ausgebildet und liegt mit seiner Spitze 46 auf einem in eine Anschlußplatte 42 eingesetzten elektrischen. Anschlußkontakt 41 auf, an den diese Spitze 46 mit dem Eigengewicht des Flachstabes 12 und bei der Prüfung von Prüflingen zusätzlich mit der von der transversal gewellten Flachfeder 19 ausgeübten Federkraft angedrückt wird. Es ist deshalb in diesem Ausführungsbeispiel der Leiter 40 nicht an den Flachstab 12, sondern wie auch in dem Ausführungsbeispiel nach Fig. 7 an den Kontakt 41 angeschlossen. Der dem Inkontaktkommen mit Prüflingen, wie 23, dienende Kontaktkopf 26' des einstückigen Stabes 12 ist hier dreizackig ausgebildet. Auch andere Ausbildungen des Kontaktkopfes 26' sind natürlich möglich.

Für die Federn solcher Stäbe 12 ist hohe Bruchsicherheit erwünscht, damit sie möglichst viele Lastwechsel ohne Bruchgefahr aushalten können. Bei den Federn 19 der Stäbe 12 nach den Figuren 1 bis 16 ist bei ebener Ausbildung der Feder 19 deren Dicke d gleich ihrer maximalen Höhe, da beide Größen hier identisch sind. Die Bruchsicherheit dieser Federn 19 ist um so größer, je größer das Verhältnis der Querschnittsbreite x (Fig. 2C) des oder der am stärksten bruchgefährdeten Querschnitte des die Federn 19 bildenden Bleches zur hierbei senkrechten Querschnittshöhe y der betreffenden Querschnitte ist. Wenn dieses Verhältnis bei den Federn nach den Figuren 1-16 für die Bruchsicherheit relativ groß gemacht wird, bspw. 1:1 oder größer, kann dies stanztechnische Probleme aufwerfen und auch zu ungünstig flachen Federkennlinien führen oder nachteilig große Blechdicken erfordern.

Die Bruchsicherheit der Feder 19 läßt sich dadurch besonders einfach erhöhen, indem das Verhältnis der Querschnittsbreite x zur Querschnittshöhe y der Querschnitte des die Feder 19 bildenden Bleches oder zumindest dessen am meisten bruchgefährdeten Querschnitte mindestens 1:1, vorzugsweise größer als 2:1 gemacht wird. Dies läßt sich gemäß einer Weiterbildung der Erfindung auf einfache Weise dadurch bei stanztechnisch günstigen Blechzuschnitten erreichen und damit die Bruchsicherheit der Feder 19 erhöhen, wobei weiterhin sehr kleine Mittenabstände in der Kontaktiervorrichtung benachbarter Federkontaktstifte erreichbar sind, indem der die Feder 19 bildende Bereich des Blechteiles des Stabes 12 zumindest teilweise zur geometrischen Breit-Längsmittelebene 61 (Fig. 22D) des Kolbengliedes 20 nicht parallel, vorzugsweise abgewinkelt verläuft, vorzugsweise um ungefähr 90° abgewinkelt ist. Eine solche Feder weist also mindestens einen Bereich auf, der aus der Ebene des Blechzuschnittes, aus dem dieser Stab gebildet ist, herausgebogen ist, wobei ggf. auch die gesamte Feder aus dieser Ebene des Blechzuschnittes herausgebogen sein kann. Bevorzugt kann dabei vorgesehen sein, daß der die Feder 19 bildende Bereich des Blechteiles des Stabes 12 gewellt und um eine zur Bewegungsrichtung des Kolbens parallele Achse um ca. 90° gedreht ist. Dabei kann zweckmäßig vorgesehen sein, daß die maximalen Breite b2 der Feder 19 größer als ihre maximale Höhe h2 und diese größer als die Dicke d des diese Feder 19 bildenden Bleches ist. Ausführungsbeispiele solcher Stäbe sind in den Fig. 17 bis 24 dargestellt.

Der infolge der eine gekrümmte Biegefeder mit gerader Längsachse bildenden Feder 19 axial federnde Stab 12 nach Fig. 17 läßt sich aus einem ebenen, vorzugsweise durch Stanzen hergestellten Blechzuschnitt 62 gemäß Fig. 18 durch Biegen herstellen, indem der Blechzuschnitt 62 anschließend an seinen das Kolbenglied 20 bildenden ebenen Bereich wie dargestellt einen rechteckförmigen schmalen langgestreckten Streifen 66 aufweist, aus dem die Feder 19 durch Biegen gebildet wird und dessen gerade Längsachse 69' mit der geraden Längsachse 69 des Kolbengliedes in diesem Ausführungsbeispiel zusammenfällt, je nach Ausführungsform ggf. jedoch auch parallel zu der in Fig. 18 dargestellten Lage etwas seitlich versetzt vorgesehen sein kann. Der vordere Längsendbereich 75 und der rückwärtige Längsendbereich 76 des Blechzuschnittes 62 bilden am fertigen Stab 12 dessen vorderen Endbereich 75 und dessen rückwärtigen Endbereich 76. Die Dicke d des Bleches des Stabes 12 kann hier bevorzugt sehr gering sein, besonders zweckmäßig ca. 0,1 bis 0,25 mm betragen. Aus diesem Streifen 66 kan die Feder 19 des Stabes 12 der Fig. 17 bevorzugt dadurch gebildet werden, indem zunächst der Streifen 66 in die Form eines Wellbleches schlangenförmig transversal zu seiner Längsrichtung gebogen wird. Danach wird diese wellen-oder wellblechförmige Feder 19 am Übergang zum Kolben 21 des Kolbengliedes 20 im Ganzen um eine in Bewegungsrichtung (Doppelfeil A) des Kolbengliedes 20 verlaufende geometrische Achse um ca. 90° in die in Fig. 17 dargestellte Stellung gedreht. Die ihrer maximalen Breite entsprechende Breite b2 dieser Feder 19 verläuft dann parallel zur Breitenerstreckung des Kolbens 21, so daß ohne weiteres die Breite b2 der Feder der Breite b1 des Kolbengliedes 20 entsprechen kann oder falls erwünscht auch kleiner oder größer sein kann, da hier wegen der Wellung der Feder quer zu deren Längsrichtung keinerlei Beschränkungen über die Größe der Breite b2 vorliegen. Das Verhältnis der hier der maximalen Höhe h2 der Feder 19 entsprechenden maximalen Querschnittsbreite x ihres senkrecht zur geometrischen Breit-Längsmittelebene des Kolbengliedes 20 verlaufenden, um 90° zur Ebene des Zuschnittes 62 gedrehten Blechbereiches zur hier der Blechdicke d entsprechenden Querschnittshöhe y kann hierdurch stanztechnisch problemlos größer als 1:1 sein, vorzugsweise wesentlich größer.

Die Federn 19 der Stäbe 12 nach den Figuren 19 und 20 haben an den am stärksten bruchgefährdeten Scheiteln ihrer Wellen ebenfalls Verhältnisse der Querschnittsbreiten x zu den Querschnittshöhen y, die bevorzugt größer, vorzugsweise wesentlich größer als 1:1 sind und sind dennoch ebenfalls stanztechnisch problemlos.

Bei der Feder 19 nach Figur 17 verläuft der diese Feder bildende Blechbereich wie dargestellt im wesentlichen senkrecht zu der geometrischen Breit-Längsmittelebene des Kolbengliedes 20, d.h., daß die beiden Breitseiten des Streifens 66, aus dem die Feder 19 gebogen ist, im wesentlichen senkrecht zur geometrischen Breit-Längsmittelebene des Kolbengliedes 20 verlaufen, da das Blech der Feder 19 fast über ihre ganze Länge senkrecht zu der genannten Breit-Längsmittelebene gerichtet ist.

Bevorzugt kann bei solchen zumindest teilweise aus der geometrischen Breit-Längsmittelebene der Kolbenglieder herausgebogenen oder abgewinkelten Federn 19 das Verhältnis der maximalen Höhe 12 der Feder 19 zur Dicke d ihres Bleches größer 1,2:1 sein, besonders zweckmäßig mindestens 2:1 betragen, oft günstig mindestens 4:1. Als besonders günstig haben sich Verhältnisse von $h_2:d$ von ca. 3:1 bis 8:1 erwiesen. Der Maximalwert des Verhältnisses x:y kann vorzugsweise größer als 1:1, bevorzugt größer als 2:1, besonders zweckmäßig größer als 4:1 sein.

Auch ist es bei diesen Ausführungsbeispielen wie auch bei sonstigen Stäben nach der Erfindung zweckmäßig, daß die maximale Breite $b_2$ dieser Feder 19 größer, vorzugsweise wesentlich größer als ihre maximale Höhe $h_2$ ist. Das Verhältnis der maximalen Breite $b_2$ zur maximalen Höhe $h_2$ der Feder 19 kann vorzugsweise 3:1 betragen, besonders günstig ist 2,5:1 bis 5:1.

Die Dicke d des Bleches des Zuschnittes 66 und damit auch die Dicke d des Bleches der Feder 19 kann vorzugsweise 0,05 bis 1 mm, besonders zweckmäßig 0,09 bis 0,4 mm betragen. Die maximale Höhe $h_2$ der Feder 19 kann besonders zweckmäßig 0,2 bis 2 mm, besonders günstig 0,4 bis 1 mm betragen.

Das Kolbenglied 21 ist in dem Ausführungsbeispiel nach Fig. 17 eben ausgebildet und seine Dicke $h_1$ entspricht der Dicke d des Bleches des Zuschnittes bildenden Bleches. Demzufolge ist in diesem Ausführungsbeispiel die Dicke $h_1$ des Kolbengliedes 20 und damit die Dicke seines Kolbens 21 erheblich kleiner als die maximale Höhe $h_2$ der Feder 19.

In Fig. 22D ist die geometrische Breit-Längsmittelebene 61 des dortigen Kolbengliedes eingezeichnet. In Fig. 17 verläuft diese Breit-Längsmittelebene parallel zu der ebenen Oberseite 70 des Kolbens 21 in halber maximaler Höhe des Kolbengliedes 20 und damit hier in halber Höhe des ebenen Kolbens 21. In dieser Breit-Längsmittelebene ist also der Streifen 66 des Zuschnittes 62 zweckmäßig zuerst transversal gewellt worden und dann nach dieser Wellung um 90° im Ganzen um eine zur geraden Längsachse 69 des Kolbengliedes 20 parallele oder mit dieser Längsachse 69 fluchtende Achse gedreht, so daß die Höhe $h_2$ der Feder 19 der in Fig. 18 entsprechend mit $h_2$ bezeichneten Breite des Streifens 66 des noch ebenen Zuschnittes 62 entspricht und die Feder 19 in ihrer endgültigen Lage parallel zur Breit-Längsmittelebene des Kolbengliedes transversal gewellt ist, wie Figur 17 anschaulich zeigt. Und zwar verlaufen die transversalen Wellen der Feder auch transversal zur geraden Längsachse des Stabes 20.

Der Stab 12 kann wieder auf irgend eine geeignete Weise an der ihn tragenden Kontaktiervorrichtung so angeordnet sein, daß sein Kolben 21 in einem Kanal von ihr geradegeführt gelagert ist. Die Feder 19 kann an der Geradführung oder an sonst irgend einem geeigneten Teil abgestützt sein, derart, daß sie beim Bewegen des Kolbengliedes 21 bezogen auf Fig. 17 nach rechts durch einen Prüfling zusammengedrückt oder stärker zusammengedrückt wird und hierdurch die Spitze 22 des Stabes 12 auf den Prüfling die zu seiner sicheren Kontaktierung erforderliche Kontaktkraft ausübt. Bspw. kann dieser Stab 12 in einer strichpunktiert angedeuteten Hülse 34' untergebracht sein, die aus dem Zuschnitt nach 62' (Fig. 18) durch Biegen gebildet sein kann. Die Biegelinien 63 des Zuschnittes 62' sind in Fig. 18 strichpunktiert eingezeichnet. Da der Kolben 21 in diesem Ausführungsbeispiel eben ist und nur die Dicke $h_1$ des ihn bildenden Bleches hat und nicht profiliert ist, muß seine Geradführung entsprechend geringe lichte Höhe haben, die mit Gleitlagerspiel geringfügig größer als $h_1$ ist. Hierzu weist die eine Gleitgeradführung für den Kolben 21 bildende und die Feder 19 ebenfalls in sich aufnehmende Hülse 34' einen vorderen Abschnitt 64 auf, der umfangsseitig geschlossen sein kann und dessen lichter Querschnitt dem Querschnitt des Kolbens 21 mit der für geringes Gleitlagerspiel erforderlichen geringfügigen Vergrößerung entspricht. An diesen Bereich 64 schließt ein dieselbe Breite, jedoch für die Aufnahme der Feder größere lichte Höhe aufweisender Längsabschnitt 65 der Hülse 34' an, in dem die Feder 19 sich befindet, wobei sie sich am rückwärtigen Ende dieses Abschnittes 65 an einem Anschlag oder dgl. abstützen kann. Der Kolben 21 kann in diesen die Feder 19 aufnehmenden Innenraum bei dem Bewegen des Kolbengliedes 20 nach rechts mehr oder weniger weit unter Zusammendrücken der Feder 19 eindringen, wobei jedoch seine Geradführung im Bereich 64 noch voll erhalten bleibt. Die Feder 19 kann vorgespannt sein und mit ihrem vorderen Ende an einer Kante des Übergangs vom Bereich 64 zum Bereich 65 der Hülse 34' anliegen. Der Abschnitt 65 kann zweckmäßig dieselbe lichte Breite wie der Abschnitt 64 aufweisen.

Die Feder 19 bildet in diesem Ausführungsbeispiel eine gewellte Blattfeder, die sich in Richtung der Längsachse 69 des Kolbengliedes 20 und damit in dessen Bewegungsrichtung wie dargestellt erstreckt und zur Längsachse 69 transversale Welle bildet, deren in halber Höhe von ihr verlaufende geometrische Wellenebene der geometrischen Breit-Längsmittelebene des Kolbengliedes 20 entsprechen oder zu ihr in vorzugsweise nur geringem Abstand parallel oder ungefähr parallel verlaufen kann.

Es ist in manchen Fällen auch möglich, vorzusehen, daß die gewellte Feder 19 in Bezug auf das Kolbenglied 20 nicht gedreht ist, d.h., daß dann die Wellenebene ihrer transversalen Wellen zur geometrischen Breit-Längsmittelebene des Kolbengliedes 20 ungefähr senkrecht verläuft.

Bei den Ausführungsbeispielen nach den Fig. 19 und 20 ist die Feder 19 relativ zur Breit-Längsmittelebene des jeweils auch hier ebenen Kolbengliedes 20 nicht im ganzen um 90° gedreht, sondern sie weist eckige schlangenförmige Windungen auf, die im wesentlichen in dieser Ebene des Kolbengliedes 20 und damit des Kolbens 21 oder schräg zu dieser Ebene verlaufen können, jedoch an den Scheiteln der ungefähren Rechteckhalbwellen zu rechteckförmigen Lappen 67, 67' ungefähr um 90° zur Ebene des Kolbens 21 abgewinkelt sind. Zu diesem Zweck hat die Feder 19 im ebenen Blechzuschnitt 62'' (Fig. 21) den dargestellten schlangenlinienförmigen Verlauf, wobei die Biegungen der Feder am Übergang vom jeweiligen Quersteg 71 zum Lappen 67 bzw. 67' jeweils nahezu 90° betragen. Diese Biegungen können ggf. auch 90° oder auch mehr oder noch weniger als 90° betragen. Jeder rechteckförmige, sich in Längsrichtung des Stabes 12 erstreckende Lappen 67,67' ist gerade und eben und diese Lappen werden durch Abwinkeln entlang den in Fig. 21 punktiert eingezeichneten Biegelinien 63 gebildet. Diese Biegelinien 63 können zweckmäßig so vorgesehen sein, daß die Breite b2 (Fig. 19) der Feder 19 ungefähr der Breite b1 des Kolbens 21 entspricht. Die Lappen 67 bzw. 67,67' sind durch Querstege 71 der betreffenden Feder 19 verbunden. Diese Querstege 71 können bei der Ausführungsform nach Fig. 19 zweckmäßig zur geometrischen Breit-Längsmittelebene des Kolbens 21 parallel sein, vorzugsweise in sie fallen. Die Querstege 71 und die Lappen 67,67' können wie dargestellt zweckmäßig gerade sein oder gewünschtenfalls auch anderen Verlauf aufweisen, bspw. bogenförmig verlaufen.

Bei dem Stab 12 nach Fig. 19 sind alle Lappen 67 von den Querstegen 71 aus nach derselben Seite abgewinkelt. Ihre außenseitig gemessene maximale Höhe entspricht der hier der maximalen Querschnittsbreite z des die Feder 19 bildenden Bleches entsprechenden maximalen Höhe h2 dieser Feder 19, wobei diese Höhe h2 wiederum wesentlich größer ist als die Dicke d des diese Feder 19 und das Kolbenglied 20 bildenden Bleches. Für die Lappen 67,67' gilt hier x=h2 und y=d, siehe Figur 24. Für die Querstege 71 der Feder 19 nach Figur 19 gilt dagegen x=d und y entspricht deren Breite. Die maximale Breite b2 der beim axialen Zusammendrücken im wesentlichen auf Biegung beanspruchten und damit eine gekrümmte Biegefeder mit gerader, sich in Bewegungsrichtung des Kolbensgliedes 20 erstreckender Längsachse bildenden.

Feder 19 kann wiederum zweckmäßig ungefähr der maximalen Breite b1 des Kolbens 21 bzw. des Kolbengliedes 20 entsprechen und größer, vorzugsweise wesentlich größer als die Höhe h2 der Feder 19 sein. Die Wellenebene der Feder 19 verläuft parallel oder ungefähr parallel zur geometrischen Längsmittelebene des Kolbengliedes 20.

Der Stab 12 nach Fig. 20 unterscheidet sich von dem Stab nach Fig. 19 im wesentlichen dadurch, daß auf der einen Seite der Feder 19 die ebenen Lappen 67 nach oben und auf der anderen Seite die ebenen Lappen 67' nach unten um zweckmäßig ungefähr 90° oder ggf. auch um etwas mehr oder auch etwas weniger als 90° abgewinkelt sind. Besonders zweckmäßig kann vorgesehen sein, daß bei dieser Feder 19 nach Fig. 20 die Querstege 71 nicht in die geometrische Breit-Längsmittelebene des Kolbengliedes 20 fallen, sondern derart schräg zu dieser Ebene stehen, daß sich die Lappen 67 und 67' in gleicher Höhe gegenüberstehen und so die maximale Höhe h2 dieser Feder 19 der außenseitig gemessenen Höhe h2 jedes beliebigen der Lappen 67. 67' und nicht der doppelten Lappenhöhe entspricht. Hierdurch wird bei gleicher Bruchfestigkeit und sonstigen praktisch gleichen Eigenschaften der Feder geringere Bauhöhe des Stabes 12 erreicht, also hier praktisch nur die halbe Bauhöhe als wenn die Querstege 71 parallel zur Ebene des Kolbens 21 verlaufen würden. Jeder durch einen Steg 71 gemäß der Schnittlinie 23-23 der Fig. 20 führende Schnitt der Feder 19 hat dann Z-förmige Gestalt, wie es Fig. 23 anschaulich zeigt. In Fig. 23 ist die geometrische, in halber Höhe der Feder 19 verlaufende Wellenebene dieser Feder 19 mit 79 bezeichnet und sie verläuft parallel oder ungefähr parallel zur geometrischen Breit-Längsmittelebene des Kolbengliedes und kann vorzugsweise dieser Breit-Längsmittelebene entsprechen.

Auch bei diesen Stäben 12 nach den Figuren 19 und 20 ist die maximale Breite b1 des Kolbengliedes 20, die ungefähr b2 entspricht, größer, vorzugsweise wesentlich größer als die maximale Höhe h2 des Stabes 12.

Bei den bei maximalem Zusammendrücken im wesentlichen auf Biegung beanspruchten, gekrümmten Biegefedern mit geraden Längsachsen bildenden Federn 10 nach den Ausführungsbeispielen gemäß Fig. 19 und 20 sind die Scheitel der schlangenförmigen Windungen der jeweiligen Feder 19 die am meisten bruchgefährdeten Bereiche. Indem die Höhe h2 dieser Lappen 67,67' größer, vorzugsweise wesentlich

größer als die Dicke d des Bleches ist, wird hierdurch also die Bruchsicherheit jeder dieser Federn 19 erheblich erhöht. Die Höhe h2 ist hier gleichzeitig die maximale Höhe dieser Stäbe 12.

In vielen Fällen ist es erwünscht und zweckmäßig, daß die maximale Höhe h1 des Kolbens 21 und ggf. des ganzen Kolbengliedes 20 ungefähr der maximalen Höhe h2 der Feder 19 entspricht, vorzugsweise gleich dieser Höhe h2 oder etwas größer als diese Höhe h2 ist, da es hierdurch möglich ist, die lichte Höhe des den Kolben 21 führenden Kanals oder dergl. entsprechend der lichten Höhe für die Feder 19 vorzusehen, so daß der lichte Querschnitt der Gleitgeradführung oder eines sonstigen für die formschlüssige Kolbenführung vorgesehenen Kanales. Schlitzes oder dergl. nicht nur im Bereich, wo der Kolben geführt wird, sondern auch in dem Bereich, wo die Feder 19 angeordnet ist, über die Länge des den Kolben 21 und die Feder 19 aufnehmenden und führenden Bereiches oder nahezu über diese Länge konstant vorgesehen sein kann. Hierzu kann bevorzugt vorgesehen sein, daß der Kolben 21 und ggf. auch noch weitere Länge des Kolbengliedes 20, ggf. das ganze Kolbenglied 20 mit einem die maximale Höhe h1 (Fig. 22A) aufweisenden Profil zu versehen, wo h1 größer als die Dicke d des das Kolbenglied 20 bildenden Bleches ist. Einige geeignete Profile hierfür sind in den Fig. 22A bis 22G dargestellt. In Fig. 22A ist dieses Profil U-förmig, in Fig. 22B Z-förmig, in Fig. 22C U-förmig mit vertieftem Boden, in Fig. 22G S-förmig, in Fig. 22E W-förmig, in Fig. 22 U-förmig mit erhöhtem mittlerem Bodenbereich und in Fig. 22G M-förmig. Für das Verhältnis der maximalen Breite b1 des durch ein solches Profil gebildeten Kolbens 21 zu dessen maximaler Höhe h1 können dann zweckmäßig ungefähr dieselben Werte gelten wie für das Verhältnis der maximalen Breite b2 zur maximalen Höhe h2 der betreffenden Feder 19, wobei vorzugsweise h1 ungefähr h2 und b1 ungefähr b2 entsprechen kann. Stäbe 12 mit solchen Kolbenprofilen können dann bspw. in Schlitze 11 einer Plattenanordnung nach Fig. 1 oder 3 oder in den Kanal oder Schlitz 11 einer Gleitgeradführung 34 nach den Fig. 11 bis 14 eingesetzt werden. Auch andere Möglichkeiten bestehen. Die Stäbe 12 können auch hier die Kontaktspitzen mit bilden oder an sie gesonderte Kontaktköpfe angesetzt sein.

Im allgemeinen ist es besonders zweckmäßig vorzusehen, daß die maximale Breite des Stabes 12 größer, vorzugsweise mindestens doppelt so groß ist wie seine maximale Höhe. Bevorzugt kann diese maximale Breite mindestens 3-fach größer, vorzugsweise 4-bis 8-fach großer als die maximale Höhe des Stabes 12 sein.

Auch kann im allgemeinen zweckmäßig die maximale Länge des Stabes 12 viel größer als seine maximale Breite sein, vorzugsweise kann diese maximale Länge mindestens 10-fach, besonders zweckmäßig mindestens 25-fach, insbesondere vorzugsweise ca. 30-bis 120-fach größer als seine maximale Breite sein.

In allen Ausführungsbeispielen sind die Stäbe 12 aus Blech durch Stanzen und ggf. noch durch Biegen bzw. Prägen des vorzugsweise gestanzten Blechzuschnittes hergestellt und haben jeweils gerade Längsachsen. Die vorderen und rückwärtigen freien Längsendbereiche 75,76 dieser Stäbe 12 sind durch die vorderen und rückwärtigen Längsendbereiche 75,76 der Blechzuschnitte gebildet, aus denen sie bestehen oder geformt sind, was unter anderem baulich und funktionsmäßig besonders günstig ist. Jeder Stab 12 ist in einem nur ihm zugeordneten Kanal 11 angeordnet. Zwischen seiner Feder 19 und seinem vorderen Ende ist jeweils nur ein einziger Kolben 21 vorhanden, der durchgehend konstante Breite (z.B. Fig. 2A) oder auch mindestens eine seine Breite bereichsweise verringernde Einbuchtung (Fig.7) aufweisen kann.

Anstatt den Kolben 21 des Kolbengliedes 20 in einem einzigen Kanal geradezuführen, kann auch vorgesehen sein, daß er in mehreren miteinander fluchtenden Kanälen oder in einer sonstigen Geradführung geradegeführt ist. Die Führung des Kolbens 21 des Kolbengliedes 20 kann besonders zweckmäßig formschlüssig in dem mindestens einen Kanal oder der sonstigen Geradführung vorgesehen sein.

In jedem solchen Kanal oder dgl. ist jeweils nur ein einziger Stab 12 angeordnet, so daß in der betreffenden Kontaktiervorrichtung einander benachbarte Stäbe 12 sich nicht berühren.

Die beim Prüfen von Prüflingen stattfindende Bewegung des Kolbengliedes 20 des betreffenden Stabes 12 findet in Richtung seiner geraden Längsachse statt.

Zumindest dann, wenn die maximale Höhe des Stabes kleiner als seine maximale Breite ist, wie bevorzugt vorgesehen, kann man den Stab als flachen Stab oder Flachstab bezeichnen. Auch ist jeder Stab 12 in der ihn führenden Führung durch seine unrunde Gestalt formschlüssig gegen Drehen gesichert.

Die Stäbe 12 nach den Fig. 17 bis 24 lassen stanztechnisch problemlos hohe Bruchsicherheit ihrer Federn bei günstigen Federkennlinien und dennoch geringen Querabmessungen erreichen und eignen sich u.a. besonders gut für Kontaktiervorrichtungen, die dem gleichzeitigen Kontaktieren aller Pads von Chips dienen, bei denen die Pads entlang allen vier Seiten des Chips in je einer geraden Reihe angeordnet sind, wobei man die jeweils eine solche Padreihe kontaktierenden Stäbe 12 oder solche Stäbe 12 aufweisende Federkontaktstifte zweckmäßig so anordnen kann, daß die Breit-Längsmittelebenen dieser Stäbe parallel zueinander sind, da dies besonders geringe Mittenabstände benachbarter Stäbe bei hoher Federbruchsicherheit und günstigen Federkennlinien problemlos ermöglicht. Dabei kann die Kontaktiervorrichtung jeweils zum gleichzeitigen Kontaktieren der Pads eines Chips oder dem gleichzeitigen Kontaktieren mehrerer oder vieler solcher Chips dienen.

**Ansprüche**

1. Kontaktiervorrichtung für Prüfvorrichtungen zum Prüfen von elektrischen oder elektronischen Prüflingen, wie Leiterplatten, integrierten Stromkreisen oder dgl., welche Kontaktiervorrichtung mindestens einen Federkontaktstift, vorzugsweise viele Federkontaktstifte aufweist, der bzw. die dem Kontaktieren von Prüflingen dienen und elektrisch leitfähig sind, wobei der Federkontaktstift ein Kolbenglied aufweist, dessen Kolben in einem Kanal geradegeführt ist, welchem Kolbenglied in axialer Richtung eine seiner Federbelastung dienende Feder nachgeordnet ist, dadurch gekennzeichnet, daß das Kolbenglied (20) und die Feder (19) des Federkontaktstiftes (12;50) gemeinsam durch ein einziges, einstückiges, aus einem Blechzuschnitt gebildetes Blechteil gebildet sind, das einen axial federnden Stab (12) bildet.

2. Kontaktiervorrichtung nach Anspruch 1, dadurch gekennzeichnet, daß das Kolbenglied (20) des Stabes (12) ein flaches Kolbenglied, vorzugsweise der ganze Stab (12) ein flacher Stab ist.

3. Kontaktiervorrichtung nach Anspruch 1 oder 2, dadurch gekennzeichnet, daß die Feder (19) und/oder der Kolben (21) des Stabes (12) einen ebenen Bereich dieses Stabes (12) bildet bzw. bilden, vorzugsweise der gesamte Stab (12) eben ausgebildet ist.

4. Kontaktiervorrichtung nach einem der vorhergehenden Ansprüche, dadurch gekennzeichnet, daß die Längsrichtung des Stabes (12) gerade ist und/oder die Feder (19) in Bezug auf die Längsrichtung des Stabes transversal gewellt ist.

5. Kontaktiervorrichtung nach einem der vorhergehenden Ansprüche, dadurch gekennzeichnet, daß der die Feder (19) bildende Blechbereich des Blechteiles des Stabes (12) zumindest teilweise zur geometrischen Breit-Längsmittelebene (61) des Kolbengliedes (20) nicht parallel verläuft, vorzugsweise zu ihr geneigt und/oder ungefähr senkrecht gerichtet ist (Fig. 17,19,20).

6. Kontaktiervorrichtung nach Anspruch 4 oder 5, dadurch gekennzeichnet daß die Wellenebene (61;79) der transversal gewellten Feder (19) parallel oder im wesentlichen parallel zu der geometrischen Breit-Längsmittelebene (61) des Kolbengliedes (20) ist, vorzugsweise ihr entspricht, vorzugsweise das die Feder (19) bildende Blech des Stabes (12) zumindest im wesentlichen ungefähr senkrecht zur geometrischen Breit-Längsmittelebene des Kolbengliedes (20) gerichtet ist (Fig. 17).

7. Kontaktiervorrichtung nach einem der Ansprüche 4 bis 4, dadurch gekennzeichnet, daß die Scheitel der transversalen Wellen der Feder (19) durch Lappen, vorzugsweise ebene Lappen (67;67') gebildet sind, die aus der durch die sie verbindenden Querstege (71) definierten Ebene vorzugsweise ungefähr rechtwinkelig abgewinkelt sind, wobei diese Lappen vorzugsweise zur geometrischen Breit-Längsmittelebene (61) des Kolbengliedes (20) ungefähr senkrecht gerichtet sind.

8. Kontaktiervorrichtung nach einem der vorhergehenden Ansprüche, dadurch gekennzeichnet, daß der Stab (12), vorzugsweise sein Kolbenglied (20), mindestens eine seiner Versteifung dienende Verformung, vorzugsweise mindestens eine Abwinklung (24) und/oder Prägung (47,48) aufweist und/oder der Stab (12) einen an die Feder (19) anschließenden Fuß (16;16') aufweist, der vorzugsweise ebenfalls einen Kolben aufweist.

9. Kontaktiervorrichtung nach einem der vorhergehenden Ansprüche, dadurch gekennzeichnet, daß der Federkontaktstift (50) eine, vorzugsweise aus Blech gebildete, gerade, gesonderte Gleitgeradführung (34) aufweist, in der der Kolben (21) des Kolbengliedes (20) axial gleitbar gelagert ist und in der vorzugsweise auch die Feder (19) angeordnet ist und daß vorzugsweise der Federkontaktstift (50) nur oder im wesentlichen aus der Gleitgeradführung (34) und dem Stab (12) besteht, wobei vorzugsweise die gesonderte Gleitgeradführung (34) eine gerade Stange mit C-förmigem Querschnitt oder eine Hülse bildet oder aufweist, und im Falle der Stange mit C-förmigem Querschnitt der Stab (12) vorzugsweise eine in den zwischen den beiden Schenkeln (43) der C-förmigen Querschnitt aufweisenden Gleitgeradführung (34) bestehenden Zwischenraum ragende Prägung (48) aufweisen kann.

10. Kontaktiervorrichtung nach Anspruch 8 oder 9, dadurch gekennzeichnet, daß die gesonderte Gleitgeradführung (34) mindestens einen Anschlag (36;36') für den Stab (12) aufweist, vorzugsweise Anschläge, zwischen denen sich die Feder (19) des Stabes befindet. wobei diese Feder (19) vorzugsweise vorgespannt sein kann.

11. Kontaktiervorrichtung nach einem der vorhergehenden Ansprüche, dadurch gekennzeichnet, daß an dem Stab (12) ein dem Inkontaktkommen mit den Prüflingen dienender Kontaktkopf (22') als gesondertes Teil befestigt ist oder daß der dem Inkontaktkommen mit den Prüflingen dienende Kontaktkopf (26') des Federkontaktstiftes durch das den einstückigen Stab (12) bildende Blechteil mit gebildet ist.

12. Kontaktiervorrichtung nach einem der Ansprüche 1 bis 8 oder 11, dadurch gekennzeichnet, daß sie einen Block, eine Platte oder einen sonstigen Gegenstand (10) aufweist, in dem bzw. in der eine Vielzahl von Känalen (11) angeordnet sind, deren Wände als Gleitgeradführungen für die Kolben (21;21;39) der in sie eingesetzten Stäbe (12) dienen und in denen vorzugsweise auch die Federn (19) der Stäbe angeordnet sind.

13. Kontaktiervorrichtung nach Anspruch 12, dadurch gekennzeichnet, daß die einstückigen Stäbe (12) allein oder falls an den Stäben (12) als gesonderte Teile ausgebildete Kontaktköpfe (22') angeordnet sind, diese Stäbe zusammen mit diesen Kontaktköpfen die Federkontaktstifte bilden.

14. Kontaktiervorrichtung nach einem der vorhergehenden Ansprüche, dadurch gekennzeichnet, daß die maximale Breite des Kolbengliedes (20) größer, vorzugsweise mindestens 2-fach größer als seine maximale Höhe ist und/oder daß die maximale Breite der Feder (19) größer, vorzugsweise mindestens 2-fach größer als ihre maximale Höhe ist und/oder daß die maximale Breite des Stabes (12) größer, vorzugsweise mindestens 2-fach größer als seine maximale Höhe ist und/oder daß die maximale Breite des Stabes (12) größer, vorzugsweise mindestens 2-fach größer, besonders zweckmäßig mindestens 3-fach größer als die Dicke des ihn bildenden Bleches ist und/oder, daß die maximale Breite des Stabes (12) ca. 4-bis 20-fach, vorzugsweise ca.4-bis 10-fach größer als die Dicke des ihn bildenden Bleches ist.

15. Kontaktiervorrichtung nach einem der vorhergehenden Ansprüche, dadurch gekennzeichnet, daß die Feder eine flache Feder (19) ist, die mindestens eine Durchbrechung (56) aufweist, vorzugsweise eine Ringreihe bildet.

16. Kontaktiervorrichtung nach einem der vorhergehenden Ansprüche, dadurch gekennzeichnet, daß die Feder (19) des Stabes (12) in einer Führung (11;34) geführt ist, die vorzugsweise auch eine Gleitgeradführung für den Kolben (21) des Kolbengliedes (20) bildet.

17. Kontaktiervorrichtung nach einem der vorhergehenden Ansprüche, dadurch gekennzeichnet, daß das den Stab (12) bildende Blechteil ein durch Stanzen und ggf. Biegen und/oder Prägen gebildetes Blechteil ist.

18. Kontaktiervorrichtung nach einem der vorhergehenden Ansprüche, dadurch gekennzeichnet, daß zumindest das Kolbenglied (20) des Stabes (12) massiv ausgebildet ist und/oder daß die Dicke des den Stab (12) bildenden Bleches ca. 0,05 bis 0,4 mm beträgt, vorzugsweise ca. 0,09 bis 0,25 mm.

19. Kontaktiervorrichtung nach einem der vorhergehenden Ansprüche, dadurch gekennzeichnet, daß das Verhältnis der Querschnittsbreite (x) zur Querschnittshöhe (Y) des Querschnittes des die Feder (49) bildenden Bleches zumindest an den am stärksten auf Biegung beanspruchten Querschnitten größer als 1:1, vorzugsweise größer als 2:1 ist.

20. Kontaktiervorrichtung nach einem der vorhergehenden Ansprüche, dadurch gekennzeichnet, daß die beiden Längsendbereiche (75,76) des Stabes durch die beiden Längsendbereiche (75,76) des Blechzuschnittes, aus dem der Stab gebildet ist, gebildet sind und/oder daß der Stab (12) der einzige in dem betreffenden Kanal (11) oder dergl. angeordnete Stab (12) ist.

FIG.1

FIG.2A

FIG.2C

FIG.3

FIG.4

FIG.5

FIG.6A

FIG.6B

FIG.7

FIG.8

FIG.9

FIG.10

FIG.2B

FIG.11

FIG.12

FIG.13

FIG.14

FIG.15

FIG.16

FIG.17

FIG.18

FIG.19

FIG.20

FIG.24

FIG.21

FIG.22A

FIG.22B

FIG.22C

FIG.22D

FIG.22E

FIG.22F

FIG.22G

FIG.23